Europäisches Patentamt

European Patent Office

Office européen des brevets

(11) Publication number: **0 371 453**
**A2**

(12) **EUROPEAN PATENT APPLICATION**

(21) Application number: 89121930.5

(51) Int. Cl.5: **H01L 39/12, H01L 39/24, C04B 35/00**

(22) Date of filing: 28.11.89

(30) Priority: 30.11.88 JP 304365/88
30.11.88 JP 304366/88

(43) Date of publication of application:
**06.06.90 Bulletin 90/23**

(84) Designated Contracting States:
. DE FR GB

(71) Applicant: **DAIKIN INDUSTRIES, LIMITED**
**Umeda Center Building, 4-12, Nakazaki-nishi**
**2-chome, Kita-ku**
**Osaka-shi, Osaka-fu(JP)**

(72) Inventor: **Koyama, Satoshi**
**4-11-32-503, Zuiko Higashiyodogawa-ku**
**Osaka-shi Osaka-fu(JP)**
Inventor: **Endo, Utako c/o Yodogawa Works**
**Daikin Industries Ltd. 1-1, Nishihitotsuya**
**Settsu-shi Osaka-fu(JP)**
Inventor: **Kawai, Tomoji**
**c/o Osaka University Sangyo Kagaku**
**Kenikyusho**
**8-1, Mihogaoka Ibaraki-shi Osaka-fu(JP)**

(74) Representative: **von Kreisler, Alek,**
**Dipl.-Chem. et al**
**Patentanwälte Von Kreisler-Selting-Werner**
**Deichmannhaus am Hauptbahnhof**
**D-5000 Köln 1(DE)**

(54) **Bismuth system oxide superconductors and preparation thereof.**

(57) A bismuth system oxide superconductive material comprising bismuth, lead, strontium, calcium, copper and oxygen and containing at least partly a phase having a tetragonal or pseudo-tetragonal system and lattice constants in the a and c axes which satisfy the following equation:
a < 0.052 x c + 3.4747,
which shows sharp decrease of electric resistance with no or little tailing around a critical temperature.

## BISMUTH SYSTEM OXIDE SUPERCONDUCTORS AND PREPARATION THEREOF

## BACKGROUND OF THE INVENTION

### Field of the Invention

The present invention relates to bismuth system oxide superconductors and preparation thereof. More particularly, the present invention relates to bismuth system oxide superconductors comprising a phase having a tetragonal or pseudo-tetragonal system and the specific lattice constants in the a and c axes.

### Description of the Related Art

The bismuth system oxide superconductor was found in January 1988 by Maeda et al (Jap. J. Appl. Phys., 27, (1988) L209). With this bismuth system oxide, sharp decrease of electric resistance was observed around 110 K and also the Meissner effect was observed in the same temperature range. Since the critical temperature $T_c$ of 110 K is much higher than 90 K of $YBa_2Cu_3O_y$ which had been believed to have the highest critical temperature, the bismuth system oxide is expected to find various applications in future.

Since the above finding by Maeda et al, extensive studies have been made on the bismuth system oxide superconductors and revealed that there are various kinds of oxide phases comprising Bi, Sr, Ca and Cu, that is, a phase having the $T_c$ of 110 K, a phase having the $T_c$ of 80 K and a semiconductive phase. The study on the structures of the bismuth system oxide indicates that all the above phases have layered structures, and that the 110 K phase, the 80 K phase and the semiconductive phase have three, two and one Cu-O layer(s) between a pair of adjacent Bi-O layers, respectively. Therefore, these phases have very different lattice constants in the c axis from each other. The 110 K phase, the 80 K phase and the semiconductive phase have the lattice constants of about 37 Å, 31 Å and 24 Å, respectively in the c axis, while the lattice constant in the a axis is substantially constant at about 5.4 Å in these three phases.

The single 110 K phase was prepared and the coexistence of three phases in one bulk was overcome (cf. Japanese Journal of Applied Physics, 27 L1476 and L1861). However, the measurement of electric resistance of various samples prepared in the above study revealed that the superconductivity varies from sample to sample. That is, in spite of the presence of the 80 K phase and/or the semiconductive phase, some samples had the zero resistance at a temperature of 100 K or higher, while some samples had a tailing on the lower temperature side in the resistance-temperature curve, which lowers an apparent critical temperature.

## SUMMARY OF THE INVENTION

One object of the present invention is to provide a bismuth system oxide superconductor resistance of which decreases sharply with no or little tailing in the resistance-temperature curve.

Another object of the present invention is to provide a bismuth system oxide superconductor having the specific lattice constants in the a and c axes.

A further object of the present invention is to provide a process for producing such bismuth system oxide superconductor.

According to one aspect of the present invention, there is provided a bismuth system oxide superconductive material comprising bismuth, lead, strontium, calcium, copper and oxygen and containing at least partly a phase having a tetragonal or pseudo-tetragonal system and lattice constants in the a and c axes which satisfy the following equation:

$$a < 0.052 \times c + 3.4747.$$

According to another aspect of the present invention, there is provided a process for producing a bismuth system oxide superconductive material of the present invention, which process comprises steps of:
mixing a bismuth compound, a lead compound, a strontium compound, a calcium compound and a copper compound,
optionally provisionally sintering the mixture, and sintering the mixture.

## BRIEF DESCRIPTION OF THE DRAWINGS

Fig. 1 shows the dependency of electric resistance on temperature of the samples prepared in Examples 1 and 2,

Fig. 2 shows the dependency of electric resistance on temperature of the samples prepared in Comparative Examples 1, 2 and 3,

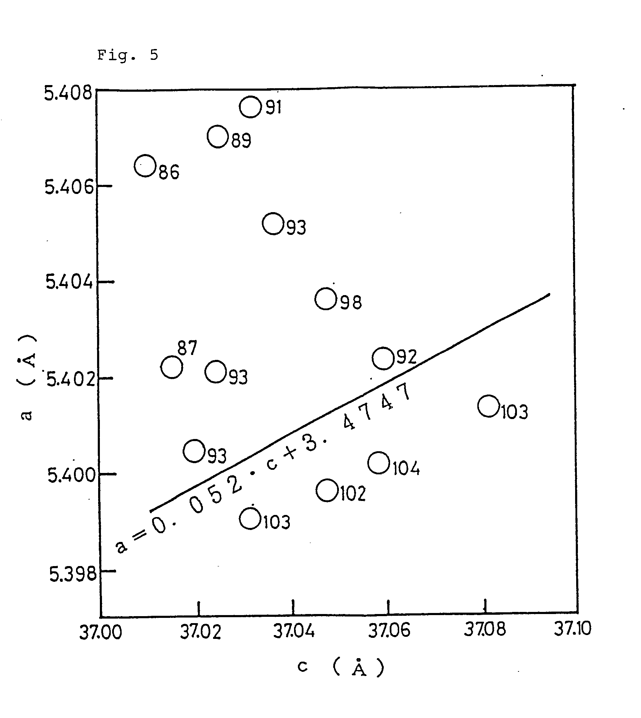

Figs. 3 and 5 shows the relationships between the lattice constants "a" and "c" of the bismuth system oxide superconductive materials, and

Fig. 4 shows dependency of electric resistance on temperature of the samples prepared in Examples 4 and 5.

## DETAILED DESCRIPTION OF THE DRAWINGS

As the phases of the bismuth system oxide superconductor, are known the 110 K phase, the 80 K phase and the semiconductive phase. The lattice constants referred herein are those in the 110 K phase.

One of the characteristics of the bismuth system oxide superconductive material according to the present invention resides in that the superconductive material contains at least partly a superconductive phase having lattice constants "a" and "c" in the a and c axes which satisfy the equation:

$a < 0.052 \times c + 3.4747$.

Herein, the units for the constants "a" and "c" are both "Å". The superconductive material of the present invention may contain the 80 K phase and/or the semiconductive phase and also some impurities.

The superconductive material of the present invention exhibits sharp decrease of resistance at the critical temperature, which will be seen from the results of Examples which are described below.

It is said that when a part of bismuth atoms of the Bi-Sr-Ca-Cu-O type superconductive material are replaced with lead atoms, the content of the 110 K phase increases. Depending on the compositions of the component atoms, the bismuth system oxide has different performances. For example, in the lead-free system, when the atomic ratio of Bi:Sr:Ca:Cu is 1:1:1:2, the proportion of the 110 K phase is maximum, while when said atomic ratio is 2:2:1:2, the 80 K phase dominates in the bismuth system oxide. According to the present invention, 10 to 40 % of bismuth atoms are replaced with lead atoms.

In the production of the bismuth system oxide superconductive material according to the present invention, the atomic ratio in the charged compounds is

$Bi_x Pb_y (Sr_u Ca_v Cu_w) O_\alpha$

wherein

$x = 0.150 - 0.215$,

$y = 0.030 - 0.090$,

$z = 0.720 - 0.800$,

$x + y + z = 1$,

$u > 0.254$,

$v > 0.257$,

$w = 0.400 - 0.430$

$u + v + w = 1$ and

$\alpha = 0.8 - 1.3$;

or $x = 0.150 - 0.215$,

$y = 0.030 - 0.090$,

$z = 0.720 - 0.800$,

$x + y + z = 1$,

$u > 0.269$, preferably $> 0.290$

$v > 0.243$,

$w > 0.430$

$u + v + w = 1$ and

$\alpha = 0.8 - 1.3$;

or $x = 0.150 - 0.215$,

$y = 0.030 - 0.090$,

$z = 0.720 - 0.800$,

$x + y + z = 1$,

$u = 0.269 - 0.290$,

$v = 0.243 - 0.275$

$w > 0.430$

3

u + v + w = 1 and
α = 0.8 - 1.3.

The raw material for supplying each of the above atoms in the bismuth system oxide may be any compound that can be converted to the corresponding oxide through the decomposition or reaction during sintering. Examples of the raw materials are hydroxides, oxides, carbonates, nitrates, oxalates, acetates and the like.

In the production, the raw materials are homogeneously mixed by any of the conventional methods. For example, the raw materials are ground and mixed in a mortar made of agate or with a ball mill. Preferably, at least copper is supplied in the form of its nitrate. More preferably, all the raw materials are supplied in the form of nitrates. The raw materials are dissolved or dispersed in a liquid medium such as water and heated to dryness while stirring. The solution or dispersion of the raw materials can be spray dried and mixed. Alternatively, a thin film formed by sputtering has a homogeneous composition. When the carbonates or oxides are used, they may be dissolved in nitric acid.

The raw material mixture prepared by the above methods is provisionally sintered before sintering, although the mixture may be sintered without provisional sintering. The mixture of the compounds other than oxide is provisionally sintered at a temperature around 800°C, for example, from 800 to 840°C in an atmosphere of the air, oxygen or a mixture of oxygen and an inert gas (e.g. nitrogen, helium, argon, etc.). It is not necessary to provisionally sinter the mixture of oxides or the thin film of oxides or metals formed by sputtering.

Then the material is sintered. When the raw materials are in the powder form, they are molded before sintering. The raw materials may be molded in any shape and/or size. For example, the molded material may be in the form of a pellet, a thin plate or a wire. The sintering is carried out usually in the air. The partial pressure of oxygen may be from 0 (zero) to 0.15 atm., preferably from 0.03 to 0.1 atom. To adjust the oxygen partial pressure, the air or pure oxygen gas may be diluted with the inert gas. The oxygen partial pressure of 0 (zero) means that no oxygen is contained and the sintering atmosphere consists of pure inert gas.

The sintering temperature varies with the oxygen partial pressure and/or the composition of the raw materials. In general, the sintering temperature is from just below the melting point of the raw material to 50°C below said melting point, preferably 30°C below said melting point. In case of the bismuth system oxide, the raw material cannot be reacted at a temperature higher than the melting point, since the once melted material has no superconductive property. The melting point of the bismuth system oxide superconductive material of the present invention is about 845°C under oxygen partial pressure of 0.2 atm. By the decrease of the oxygen partial pressure, the oxide product can be produced in a comparatively short time in a wide temperature range.

The sintering time is at least 2 hours, preferably at least 8 hours, more preferably at least 12 hours.

The sintered oxide material is cooled preferably in an atmosphere having an oxygen partial pressure higher than that in the sintering step, while it may be cooled in the atmosphere having the same oxygen partial pressure as in the sintering step. Through the bismuth system oxide cooled in the atmosphere having the higher oxygen partial pressure, a larger amount of current can be flowed. Alternatively, the sintered oxide is cooled under the same oxygen partial pressure as in the sintering step, reheated at a temperature lower than the sintering temperature and treated with oxygen under the higher oxygen pressure.

## PREFERRED EMBODIMENTS OF THE INVENTION

The present invention will be illustrated more in detail by following examples.

## Examples 1 and 2

$Bi_2O_3$, PbO, $SrCO_3$, $CaCO_3$ and CuO were weighed so that the atomic ratio of Bi:Pb:Sr:Ca:Cu was 1.84:0.34:2.06:1.99:2.95, which corresponded to the composition of $Bi_xPb_y(Sr_uCa_vCu_w)O_\alpha$ in which x = 0.200, y = 0.037, z = 0.763, u = 0.294, v = 0.284 and w = 0.421.

The raw material oxides were completely dissolved in excess nitric acid while heating. The solution was charged in an evaporating dish made of platinum and heated while continuous stirring to evaporate water off. During evaporation, excess nitric acid was also removed. The mixture of formed nitrates was taken in an alumina crucible and further heated, whereby the nitrates were decomposed with liberation of $NO_2$. The

4

heating was continued at 800°C till no $NO_2$ was liberated. The mixture was ground in an agate mortar and molded in a round plate of 13 mm in diameter and about 1 mm in thickness.

Then, the molded plate was placed in an alumina boat and set at a center of a tubular furnace of 100 mm in inner diameter and 600 mm in length. The plate was sintered at 835°C for 12 hours with flowing a mixture of argon and oxygen in a volume ratio of 12:1 at a flow rate of 250 ml/min. After cooling to room temperature, the sintered plate was ground, re-molded in a round plate having the same sizes as above and again sintered for 72 hours under the same conditions as above. The plate was cooled to room temperature at a cooling rate of about 2°C/min. to obtain the sample of Example 1.

In Example 2, the sample was prepared in the same manner as in Example 1 but weighing the raw materials so that the atomic ratio corresponded to the composition of $Bi_xPb_y(Sr_uCa_vCu_w)O_\alpha$ in which x = 0.200, y = 0.037, z = 0.763, u = 0.278, v = 0.294 and w = 0.428.

The X-ray diffraction analysis of these samples gave the lattice constants "a" and "c" shown in Table 1.

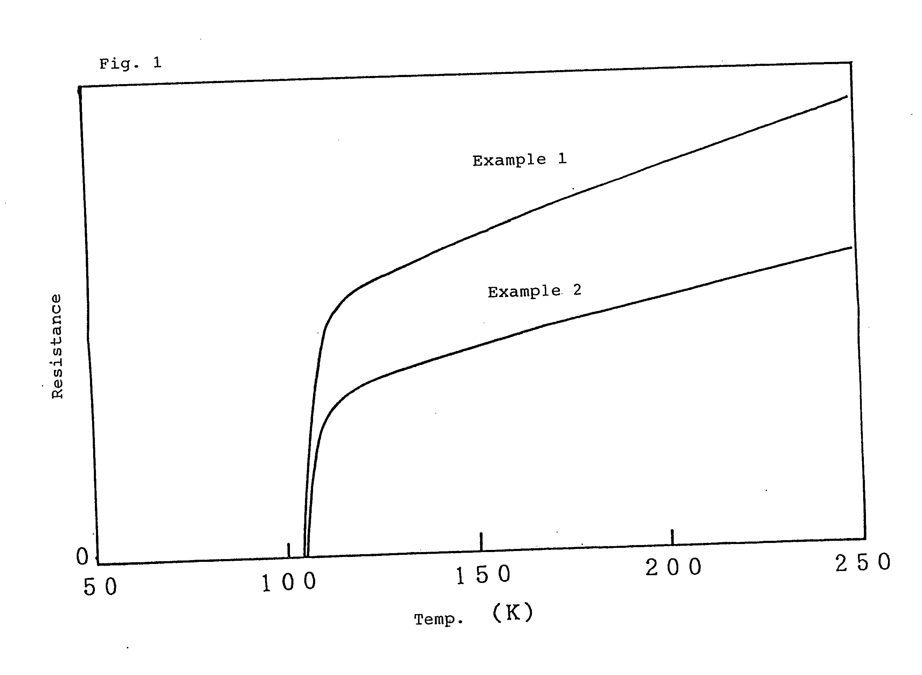

Dependency of electric resistance of each sample was measured. The results are shown in Fig. 1. The resistance started to decrease sharply around 110 K and reached 0 (zero) at 103 K (Example 1) and 104 K (Example 2).

Comparative Examples 1, 2 and 3

The sample was prepared in the same manner as in Example 1 but weighing the raw materials so that the atomic ratio corresponded to the composition of $Bi_xPb_y(Sr_uCa_vCu_w)O_\alpha$ in which x = 0.200, y = 0.037, z = 0.763, u = 0.260, v = 0.303 and w = 0.437 (in Comparative Example 1), x = 0.200, y = 0.037, z = 0.763, u = 0.240, v = 0.310 and w = 0.450 (in Comparative Example 2) or x = 0.200, y = 0.037, z = 0.763, u = 0.253, v = 0.284 and w = 0.463 (in Comparative Example 3).

The X-ray diffraction analysis of these samples gave the lattice constants "a" and "c" shown in Table 1.

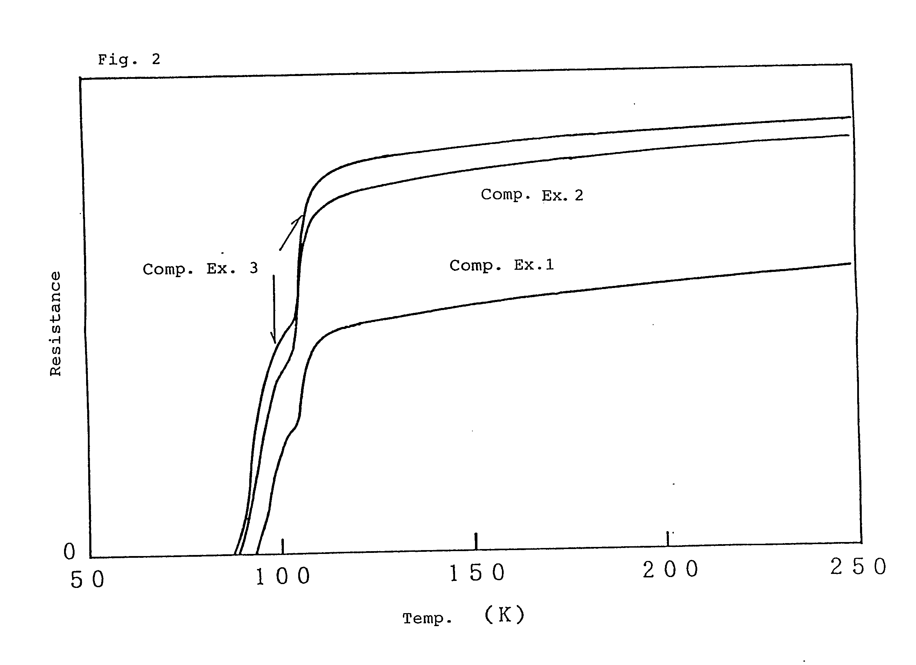

Dependency of electric resistance of each sample was measured. The results are shown in Fig. 2. The resistance started to decrease comparatively sharply at about 110 K but tailed. The resistance reached 0 (zero) at 93 K (Comparative Example 1), 89 K (Comparative Example 2) and 87 K (Comparative Example 3).

Example 3

In this Example, the sample was prepared by a solid phase reaction.

$Bi_2O_3$, PbO, $SrCO_3$, $CaCO_3$ and CuO were weighed so that the atomic ratio of Bi:Pb:Sr:Ca:Cu was the same as that in Example 1 and throughly mixed in the agate mortar. The mixture was provisionally sintered at 810°C for 10 hours while flowing the air. Thereafter, the grinding and the three hour provisional sintering were repeated twice. The provisionally sintered mixture was again ground and molded to obtain a round plate of 13 mm in diameter and about 1 mm in thickness. Then, the plate was sintered in the same manner as in Example 1 but heating the plate at 842°C for 80 hours, followed by gradual cooling to room temperature under oxygen partial pressure of 1/13 atm. at cooling rate of about 2°C/min.

The sintered round plate was slightly warped. This indicates that the sintering was carried out just below the melting point.

The X-ray diffraction analysis of these samples gave the lattice constants "a" and "c" shown in Table 1.

Dependency of electric resistance of each sample was measured. The electric resistance reached 0 (zero) at 104 K.

Table 1

| Example No. | a (Å) | c (Å) | Zero resistance temp. (°C) |
|---|---|---|---|
| 1 | 5.400 | 37.082 | 103 |
| 2 | 5.402 | 37.071 | 104 |
| 3 | 5.401 | 37.080 | 104 |
| Comp. 1 | 5.405 | 37.037 | 93 |
| Comp. 2 | 5.407 | 37.026 | 89 |
| Comp. 3 | 5.402 | 37.016 | 87 |

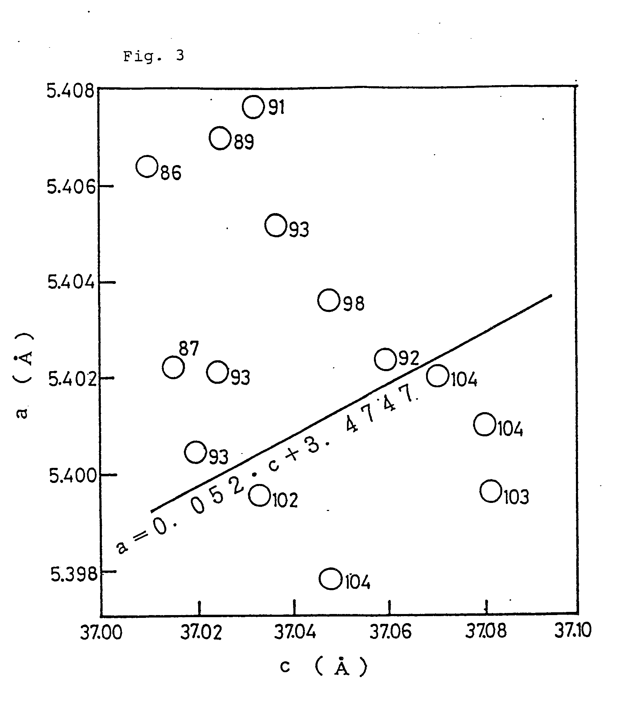

Fig. 3 shows the relationships between the lattice constants "a" and "c" of the samples prepared in Examples 1-3 and Comparative Examples 1-3 and by other processes.

The numerals attached to the plots indicate the zero resistance temperatures. Only when the plot is present lower than the line: $a = 0.052 \times c + 3.4747$, the critical temperature is higher than 100 K. In general, the smaller "a" is preferred, but when the "c" is small, the critical temperature decreases. When "c" is large and also "a" is large, the critical temperature is low. Accordingly, the lattice constants "a" and "c" should satisfy the equation:

$$a < 0.052 \times c + 3.4747.$$

### Examples 4 and 5

A sample was prepared in the same manner as in Example 1 but weighing $Bi_2O_3$, $PbO$, $SrCO_3$, $CaCO_3$ and $CuO$ so that the atomic ratio of Bi:Pb:Sr:Ca:Cu was 1.84:0.34:2.04:1.90:3.06 which corresponded to the composition of $Bi_xPb_y(Sr_uCa_vCu_w)O_\alpha$ in which $x = 0.200$, $y = 0.037$, $z = 0.763$, $u = 0.291$, $v = 0.271$ and $w = 0.437$ (in Example 4) or so that the atomic ratio corresponded to the composition of $Bi_xPb_y(Sr_uCa_vCu_w)O_\alpha$ in which $x = 0.200$, $y = 0.037$, $z = 0.763$, $u = 0.275$, $v = 0.275$ and $w = 0.450$ (in Example 5).

The X-ray diffraction analysis of these samples gave the lattice constants "a" and "c" shown in Table 2.

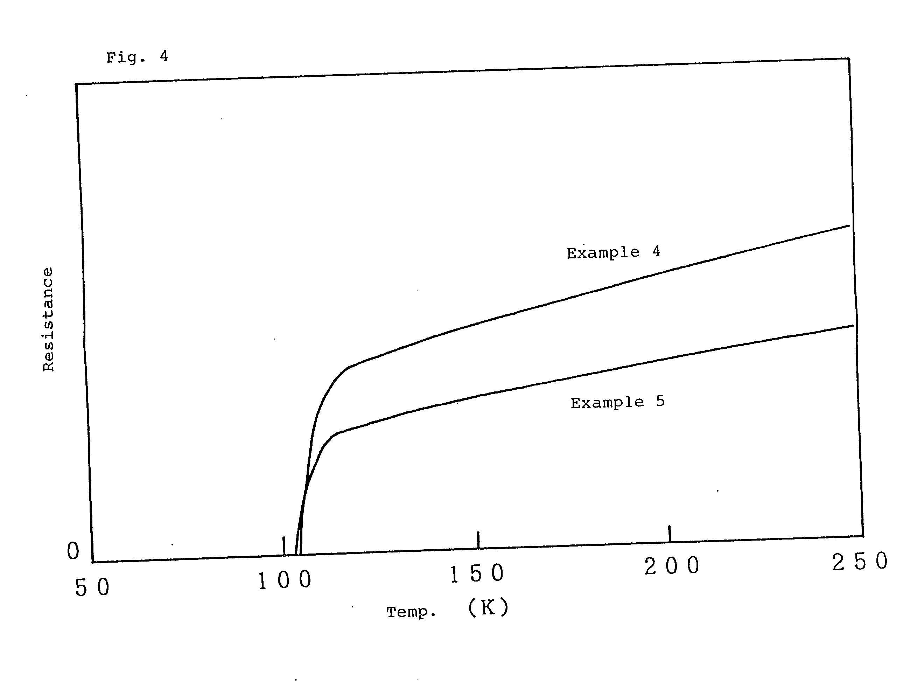

Dependency of electric resistance of each sample was measured. The results are shown in Fig. 4. The resis tance started to decrease sharply at about 110 K and reached 0 (zero) at 104 K (Example 4) and 103 K (Example 5).

### Example 6

In the same manner as in Example 3 but the raw materials were weight in the same atomic ratio as in Example 4, a sample was prepared.

The X-ray diffraction analysis of these samples gave the lattice constants "a" and "c" shown in Table 2.

Dependency of electric resistance of each sample was measured. The resistance reached 0 (zero) at 103 K.

EP 0 371 453 A2

Table 2

| Example No. | a (Å) | c (Å) | Zero resistance temp. (°C) |
|---|---|---|---|
| 4 | 5.400 | 37.059 | 104 |
| 5 | 5.399 | 37.032 | 103 |
| 6 | 5.401 | 37.082 | 103 |
| Comp. 1 | 5.405 | 37.037 | 93 |
| Comp. 2 | 5.407 | 37.026 | 89 |
| Comp. 3 | 5.402 | 37.016 | 87 |

**Claims**

1. A bismuth system oxide superconductive material comprising bismuth, lead, strontium, calcium, copper and oxygen and containing at least partly a phase having a tetragonal or pseudo-tetragonal system and lattice constants "a" and "c" (Å) in the a and c axes which satisfy the following equation:
$a < 0.052 \times c + 3.4747$.

2. The bismuth system oxide superconductive material according to claim 1, which is obtainable by charging a bismuth compound, a lead compound, a strontium compound, a calcium compound and a copper compound in amounts which correspond to the composition:
$Bi_xPb_y(Sr_uCa_vCu_w)O_\alpha$
wherein
$x = 0.150 - 0.215$,
$y = 0.030 - 0.090$,
$z = 0.720 - 0.800$,
$x + y + x = 1$,
$u > 0.254$,
$v > 0.257$,
$w = 0.400 - 0.430$
$u + v + w = 1$ and
$\alpha = 0.8 - 1.3$.

3. The bismuth system oxide superconductive material according to claim 1, which is obtainable by charging a bismuth compound, a lead compound, a strontium compound, a calcium compound and a copper compound in amounts which corresponds to the composition:
$Bi_xPb_y(Sr_uCa_vCu_w)O_\alpha$
wherein
$x = 0.150 - 0.215$,
$y = 0.030 - 0.090$,
$z = 0.720 - 0.800$,
$x + y + z = 1$,
$u > 0.269$,
$v > 0.243$,
$w > 0.430$
$u + v + w = 1$ and
$\alpha - 0.8 - 1.3$.

4. The bismuth system oxide superconductive material according to claim 3, wherein u is larger than 0.290.

5. The bismuth system oxide superconductive material according to claim 1, which is obtainable by charging a bismuth compound, a lead compound, a strontium compound, a calcium compound and a copper compound in amounts which correspond to the composition:
the atomic ratio in the charged compounds is

7

$Bi_xPb_y(Sr_uCa_vCu_w)O_\alpha$
wherein
$x = 0.150 - 0.215$,
$y = 0.030 - 0.090$,
$z = 0.720 - 0.800$,
$x + y + z = 1$,
$u = 0.269 - 0.290$,
$v = 0.243 - 0.275$
$w > 0.430$
$u + v + w = 1$ and
$\alpha = 0.8 - 1.3$.

6. A process for preparing a bismuth system oxide superconductive material comprising bismuth, lead, strontium, calcium, copper and oxygen and containing at least partly a phase having a tetragonal or pseudo-tetragonal system and lattice constants in the a and c axes which satisfy the following equation:

$a < 0.052 \times c + 3.4747$,

which process comprises steps of:

mixing a bismuth compound, a lead compound, a strontium compound, a calcium compound and a copper compound,

optionally provisionally sintering the mixture, and sintering the mixture.

7. The process according to claim 6, wherein at least the copper compound is copper nitrate.

8. The process according to claim 6, wherein the bismuth compound, the lead compound, the strontium compound, the calcium compound and the copper compound are all nitrates.

9. The process according to claim 8, wherein the nitrates are dissolved in a liquid medium, the medium is removed, and then the nitrates are converted to corresponding oixdes by heating.

10. The process according to claim 6, wherein the sintering is carried out under oxygen partial pressure of not higher than 0.15 atm.

Fig. 1

Fig. 2

Resistance

Comp. Ex. 3

Comp. Ex. 2

Comp. Ex.1

0

50    100    150    200    250

Temp. (K)

EP 0 371 453 A2

Fig. 3

Fig. 4

EP 0 371 453 A2

Fig. 5